(19) **Europäisches Patentamt**
**European Patent Office**
**Office européen des brevets**

(11) **EP 3 524 988 B1**

(12) **EUROPEAN PATENT SPECIFICATION**

(45) Date of publication and mention
of the grant of the patent:
**30.03.2022 Bulletin 2022/13**

(51) International Patent Classification (IPC):
***G01R 31/28*** (2006.01)

(52) Cooperative Patent Classification (CPC):
**G01R 31/2812**

(21) Application number: **19155971.5**

(22) Date of filing: **07.02.2019**

(54) **A METHOD OF AND APPARATUS FOR DETECTING CHANNEL IMBALANCE IN A DIFFERENTIAL SIGNAL SYSTEM COMPRISING A DIFFERENTIAL AMPLIFIER**

VERFAHREN UND VORRICHTUNG ZUM ERFASSEN VON KANALUNGLEICHGEWICHTEN IN EINEM DIFFERENTIALSIGNALSYSTEM MIT EINEM DIFFERENTIALVERSTÄRKER

PROCÉDÉ ET APPAREIL DE DÉTECTION D'UN DÉSÉQUILIBRE DE CANAL DANS UN SYSTÈME DE SIGNAL DIFFÉRENTIEL COMPRENANT UN AMPLIFICATEUR DIFFÉRENTIEL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.02.2018 GB 201801995**
**02.05.2018 US 201815969242**

(43) Date of publication of application:
**14.08.2019 Bulletin 2019/33**

(73) Proprietor: **Analog Devices International Unlimited Company**
**Limerick (IE)**

(72) Inventors:
• **HURWITZ, Jonathan Ephraim David**
**Edinburgh, Lothian EH6 7JP (GB)**
• **BYRNE, Eamonn**
**Co. Limerick, V94 49N7 (IE)**
• **BONACHE, Jesus**
**C.P. 46017 Valencia (ES)**
• **SYTHES, Robert**
**Co. Laois, R32 XPK1 (IE)**

(74) Representative: **Thompson, Andrew John**
**Withers & Rogers LLP**
**2 London Bridge**
**London SE1 9RA (GB)**

(56) References cited:
**EP-A2- 2 538 626      CA-A1- 2 255 975**
**US-A1- 2008 100 308      US-B1- 6 469 520**
**US-B1- 8 891 595**

**Description**

<u>FIELD</u>

The present disclosure relates to a method of and apparatus for electrical or other signal processing.

<u>BACKGROUND</u>

There are many circumstances where a transducer may be located remotely from an apparatus which is responsive to the signal from the transducer. The interconnection between the transducer and the signal processing apparatus may be made by way of a conductor, such as a wire, which may interface with plugs and sockets in order that the circuit may be made. Such an arrangement may be susceptible to damage, by way of physical shock causing the cable to become broken, thermal cycling or vibratory movements causing the insulation to become damaged or corrosion of the pins making the connections between the transducer and the measuring apparatus.

US patent publication US2008/0100308 relates to a device for measuring imbalances in a telecommunications line. The circuit includes an adjustable sine wave burst generator which generates an ac signal that is transmitted across the balanced pathways. A differential amplifier in the circuit measures this difference and displays it in units of noise or balance.

<u>SUMMARY OF THE DISCLOSURE</u>

The present inventors have recognized, among other things, that it is desirable to be able to distinguish between failure of the connection and situations where the output of the transducer is low or non-existent. In each case, it can be seen that a signal that is being looked for would be largely absent.

The present disclosure relates to a method of and an apparatus for detecting an out-of-range impedance, such as a higher than expected impedance condition, at an input to a signal processing apparatus. The condition may be indicative of failure of a connection between the signal processing apparatus and an input circuit whose impedance is broadly known, at least within a specified range of values. More generally, the teachings herein can be used to detect an impedance change in both increasing and decreasing directions of change. The teachings of the present disclosure may also be used to identify channel imbalance within a differential signal processing system, such as a differential amplifier. Such identification can be used to address the imbalance by adjusting component values within the differential system. The invention is defined according to the independent claims. The optional features are defined by the dependent claims.

<u>BRIEF DESCRIPTION OF THE DRAWINGS</u>

Embodiments of the present disclosure will now be described, by way of non-limiting example only, with reference to the accompanying Figures in which:

Figure 1 is a circuit diagram of an amplifier, where the amplifier has a dual ended (differential) output and the gain (which also includes the possibility of attenuation) of the amplifier is set by resistors $R_1$ and $R_2$.

Figure 2 shows a circuit symbol of a dual ended differential amplifier with common mode output voltage control.

Figure 3 shows a further circuit symbol of a dual ended differential amplifier with a common mode output voltage control.

Figure 4 schematically illustrates, merely by way of general background information, an embodiment of an amplifier having common mode voltage control;

Figure 5 schematically illustrates a measurement circuit that is used to amplify the output of a transducer;

Figure 6 shows a modification of Figure 5 with the inclusion of a low pass (anti-aliasing) filter;

Figure 7 illustrates how the circuit of Figure 6 can be modified to include input mismatch and/or an open circuit detection capability;

Figure 8 schematically illustrates an analog embodiment of a processing unit for detecting an open circuit;

Figure 9 schematically illustrates a digital embodiment of a processing unit for detecting an open circuit;

Figure 10 shows a flow chart for open circuit detection; and

Figure 11 shows an embodiment of a channel mismatch detector.

DESCRIPTION OF SOME EMBODIMENTS

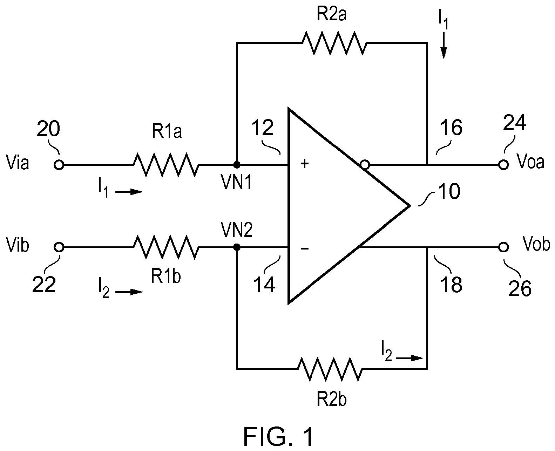

In signal amplification and instrumentation, difference amplifiers can be used at an input stage for processing analog signals from transducers. Figure 1 schematically illustrates a circuit diagram of a common difference amplifier configuration, i.e. a differential amplifier having a differential or dual ended output, rather than a single ended output. In the arrangement shown in Figure 1, the difference amplifier, generally designated 10, has a non-inverting input 12 and an inverting input 14. It also has an inverting output 16 and a non-inverting output 18. The amplifier receives signals via first and second input nodes 20 and 22, which can be regarded as non-inverting and inverting input nodes respectively, and provides a differential output to output nodes 24 and 26 which can be regarded as inverted and non-inverted outputs, respectively.

Gain equations can be established for the operation of a single ended differential amplifier. A dual ended amplifier is shown in Figure 1. If the circuit components are selected such that the input resistor $R_{1a}$ is equal to the input resistor $R_{1b}$ ($R_{1a} = R_{1b} = R_1$) and that feedback resistor $R_{2a}$ is equal to feedback resistor $R_{2b}$ ($R_{2a} = R_{2b} = R_2$), as is commonly the case, then the differential gain of that circuit is $\dfrac{-R_2}{R_1}$ .

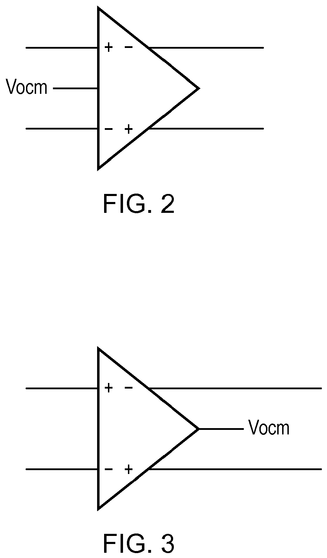

In certain amplifiers, a the common mode voltage can be set via a control terminal. Circuit symbols of such amplifiers are shown in Figures 2 and 3.

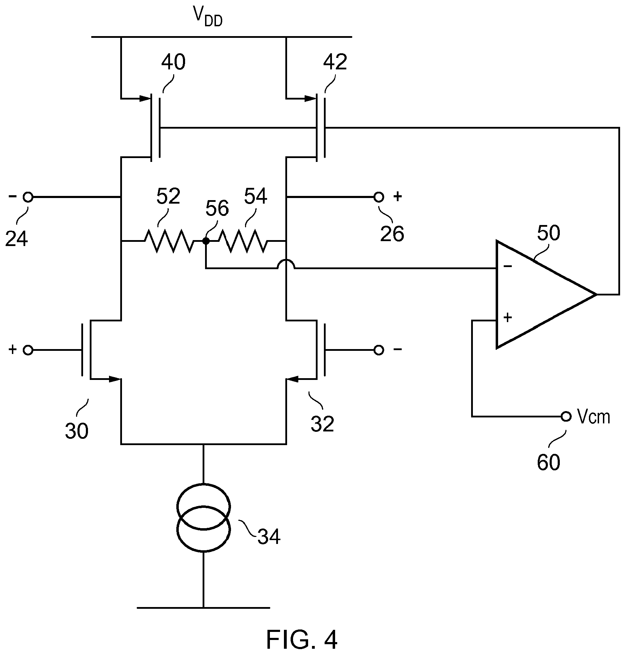

Whilst the construction of such an amplifier need not be detailed in the teachings of the present disclosure, save for the fact that some of the embodiments of the disclosure use such a device, a simplified circuit diagram for a differential amplifier having differential outputs and the ability to set the common mode value of the outputs to a target value is shown in Figure 4.

The differential amplifier shown in Figure 4 comprises first and second input transistors 30 and 32 with their sources connected to a current sink 34, thereby forming the well-known long-tail pair configuration. The drains of the transistors 30 and 32 are connected to the positive supply rail Vdd by way of P-type FETs 40 and 42 which serve to form active loads, and whose gates are connected so as to receive a control voltage from a further differential amplifier 50 provided within the amplifier circuit for the purposes of controlling the common mode output voltage. The differential output voltage can be obtained at nodes 24 and 26 connected to the drains of the first and second transistors 30 and 32, respectively.

In order to provide the common mode voltage control function the circuit further includes a voltage divider comprising resistors 52 and 54 extending between the drains of the first and second transistors 30 and 32 so as to form the common mode output voltage at an internal node 56. The internal node 56 is connected to the inverting input of the further differential amplifier 50. The non-inverting input of the further differential amplifier 50 is connected to the common mode adjustment pin 60 which receives a common mode target voltage $V_{cm}$. The output of the further differential amplifier 50 provides the gate voltage for the load transistors 40 and 42. Such an arrangement provides a differential amplifier whose common mode voltage can be adjusted. Integrated circuits, such as the AD8137 available from Analog Devices can include this capability. The AD8137 dates from 2004.

The present inventors realized, among other things, that the ability to modulate the common mode output voltage could be exploited to look for impedance imbalance within the input path to a difference amplifier, and that this can be used both to improve the common mode rejection ratio of such an amplifier and/or look for fault conditions such as disconnection of a signal path from a transducer or other input arrangement to a differential amplifier.

Returning to Figure 1, we can perform an analysis to indicate how modification of the common mode output voltage can be used to interrogate the common mode rejection performance of the amplifier and/or to look for disconnection in signal paths to the input nodes 20 and 22.

Given that the current at the inputs of an operational amplifier is very low, we can write the input currents at the input nodes in terms of the circuit voltage.

$$I_1 = \frac{V_{ia} - V_{oa}}{R_{1a} + R_{2a}}$$

$$I_2 = \frac{V_{ib} - V_{ob}}{R_{1b} + R_{2b}}$$

We can express the output voltages $V_{oa}$ and $V_{ob}$ as a combination of a common mode voltage and $V_{cm}$ and a differential voltage $V_{od}$ where $V_{oa}$ - $V_{ob}$ = $2V_{od}$.

For simplicity, let's assume $R_{1a} = R_{1b} = R_1 \; R_{2a} = R_{2b} = R_2$

$$\therefore I_1 = \frac{V_{ia} - V_{cm} - V_{od}}{R_1 + R_2}$$

$$I_2 = \frac{V_{ib} - V_{cm} + V_{od}}{R_1 + R_2}$$

If we further make the assumption that Via and Vib have been connected to a reference node, such as 0V, then we also know that the differential component $V_{od}$ will be zero.

$$\therefore I_1 = \frac{-V_{cm}}{R_1 + R_2}$$

$$I_2 = \frac{-V_{cm}}{R_1 + R_2}$$

This demonstrates that one can adjust the current drawn at the input of the amplifier by adjusting the common mode output voltage.

Put another way, one has a tool to deliberately modulate the current drawn by the amplifier, without requiring any additional circuitry at the input of the amplifier, and in so doing can examine the properties of the input circuitry.

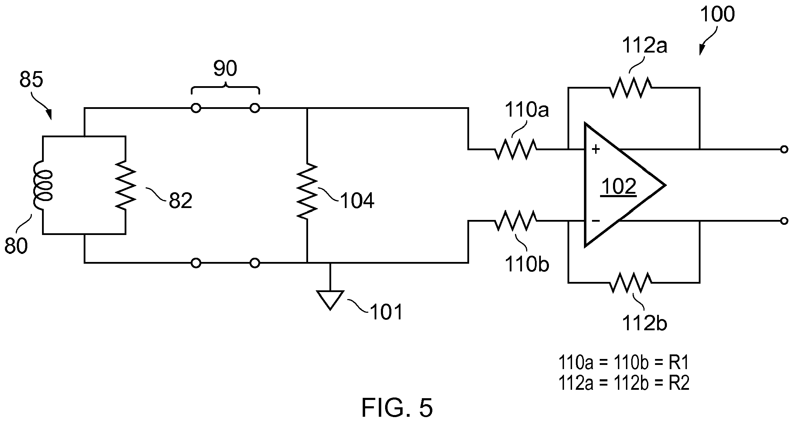

Figure 5 schematically illustrates the use of a difference amplifier 100 to receive and amplify a differential signal from a magnetic transducer, such as a current transformer or a Rogowski coil. The magnetic coil of the current transformer 80 is connected across a burden resistor 82 in order to transform the induced current therein into the voltage domain (in the case of a Rogowski coil which is typically a low impedance the burden resistor is typically omitted). The current transducer 80 and burden resistor 82 effectively form an input circuit 85. The input circuit is connected to the difference amplifier 100 by way of a conductor 90 which may extend over quite some distance. If the conductor 90 becomes broken then no input signal can be received at the difference amplifier 100. However, it also transpires that if no alternating current is being drawn by a conductor near the coil of the current transformer 80, then there is little or no signal received at the difference amplifier 100 even though the intervening conductor 90 is intact.

A further consideration in such circuits is that in the event of the conductor 90 becoming broken the circuit designer does not want either the inverting or non-inverting input of the difference amplifier left floating. In order to address this, a ground connection 101 is made adjacent the input stage of the amplifier and a high value resistor 104 is connected between the non-inverting and inverting inputs. If the conductor 90 becomes broken then both of the inputs of the amplifier are connected to ground. In the example shown in Figure 5 the non-inverting input is connected to ground 101 by way of the input resistor 100a in series with the impedance 104. The non-inverting input is connected to ground by way of the input resistor 110b. If the conductor 90 is connected and intact, then the resistors 82 and 104 and the impedance of the current transformer appear in parallel. For simplicity we shall assume that the resistance of the parallel combination of the impedance of the current transformer and the burden resistor can be represented solely by the burden resistor. In a typical installation the resistor 82 is many times smaller in value than the resistor 104 and hence the parallel combination of the resistors 82 and 104 is effectively the same value as resistor 82. In general, although not of strict necessity, one may choose to tend to set the resistors such that the resistor 110a is the same value as resistor 110b. Similarly the feedback resistors 112a and 112b are set to the same value. For convenience later on, it will be assumed that the resistors 110a and 110b have a value $R_1$ and resistors 112a and 112b have a value $R_2$.

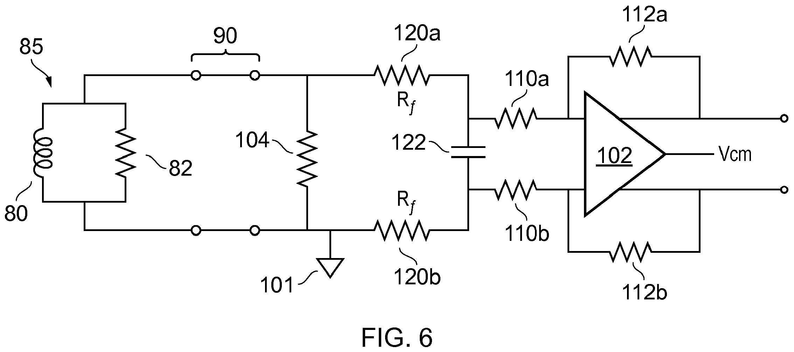

The circuit configuration of Figure 5 is often modified by the inclusion of a low pass filter, which serves as an anti-aliasing filter, at the input of the amplifier. In Figure 6 the anti-aliasing filter is formed by resistors 120a, 120b and capacitor 122. The resistor 120a is interposed in series with the resistor 110a and the connector 90. The resistor 120b is interposed between the resistor 104 and the resistor 110b. The capacitor 122 extends between a first node formed at the junction between the resistors 120a and 110a and a second node formed at the connection between resistors 120b and 110b. The resistors 120a and 120b have the same value, generally, and in this circuit diagram have the value Rf.

The amplifier in Figure 6 also has a common mode setting terminal to receive a control signal such that the common mode value of the output of the amplifier is $V_{cm}$, being the same as the voltage supplied at the common mode voltage setting terminal of the amplifier.

In this configuration it can be seen that a change in differential output voltage can be related to the common mode output voltage by the following equation:

$$V_o = - \frac{2\,R_2\,R_{pd}\,V_{cm}}{2\,R_1^2 + \left(2\,R_1 + 2\,R_f + R_{pd}\right)R_2 + 2\,R_1\left(2\,R_f + R_{pd}\right) + 2R_f^2 + 2\,R_f\,R_{pd}}$$

in this equation the resistor 104 has the value $R_{pd}$.

If the connection to the input transducer is intact then the resistance $R_{pd}$ becomes replaced by the impedance of the input transducer, e.g. the parallel combination of the current transformer and burden resistor. In a low frequency regime this impendence is essentially that of the burden resistor 82, which is typically 100 ohms or so.

It therefore follows that modulating the common mode output voltage gives a change in the differential output voltage, where the magnitude of that change depends on whether the input transducer 85 is connected to the differential amplifier or not. Consequently the magnitude of the change in the differential voltage can be examined and used to indicate failure of a connector 90, and more specifically to distinguish between situations where the transducer is working correctly and is connected to the amplifier but there is no signal to the output, and those situations where the connector 90 has failed.

Merely by way of example if

$$\text{if} \qquad R1 \;\; = \; 1M\Omega$$

$$R2 \;\; = \; 400K\Omega$$

$$Rf \;\; = \; 30K\Omega$$

$$Rpd \;\; = \; 100K\Omega$$

then

$$\frac{dV_o}{dV_{cm}} = \; -25_m V/V$$

but if conductor 90 is working then $R_{pd}$ becomes shorted by $R_B$, then the burden resistor, of approximately 100$\Omega$, then

$$\frac{dV_o}{dV_{cm}} = \; -25_\mu V/V$$

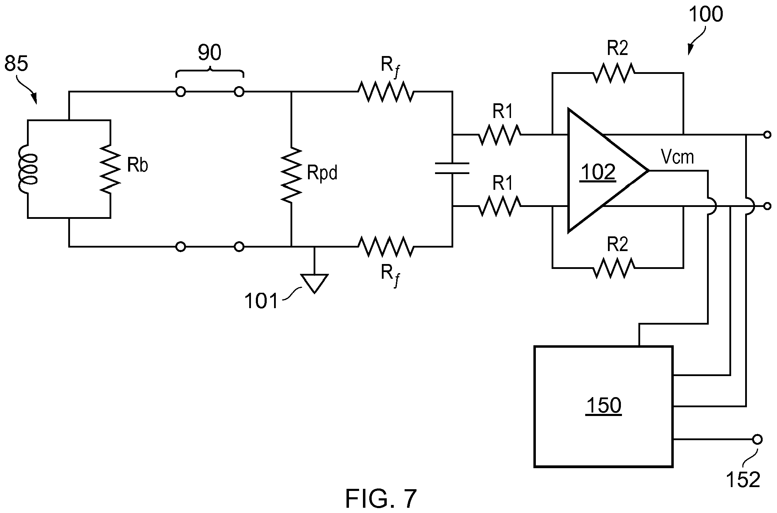

Figure 7 schematically shows the circuit of Figure 6 with the addition of a data processor (including analog to digital converters and digital to analog converters)150 which is operable to monitor the differential output of the amplifier and, if necessary, to modulate or otherwise vary the target common mode output voltage $V_{cm}$. The processing circuit 150 can be implemented in various forms, such as dedicated digital hardware, dedicated analog hardware, a mixed mode solution or by the reuse of processors and analog to digital converters and digital to analog converters that may have been provided to perform other tasks and which have spare capacity or can be repurposed. The status of the connection 90, i.e. good or failed can be output as a signal at node 152.

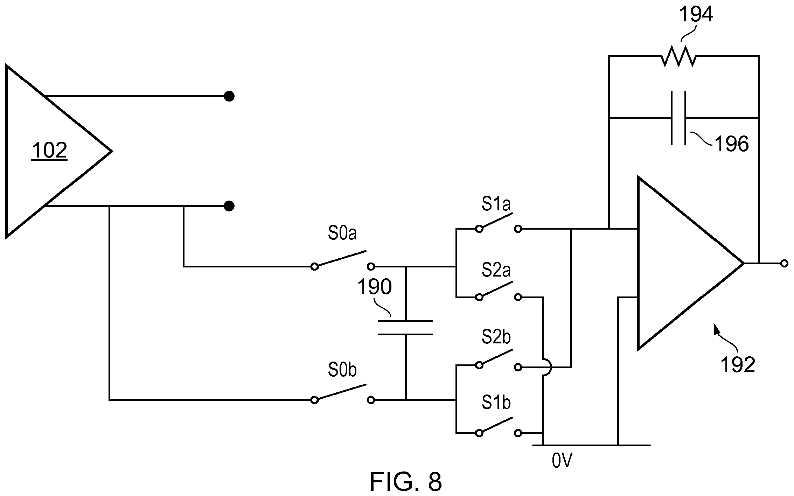

An embodiment of an analog implementation of the circuit 150 is shown in Figure 8. The output of the amplifier can be provided to an integrator that acts to integrate the difference between the two outputs of the amplifier during the periods where the common mode control signal Vcm has a first value, Vcm1, and those periods where the common mode control signal has a second value Vcm2. The voltage Vcm can be switched between Vcm1 and Vcm2 in an alternating fashion. This integration can be performed by sampling the differential output signal from the amplifier 102 onto a capacitor 190, and then charge sharing the sampled charge with a leaky integrator 192, and where the switches associated with the capacitor 190 allow it to be swapped over such that the charge can be additive or subtractive with the result of the integrator. To do this the capacitor is associated with three pairs of switches. A first pair of switches SOa, SOb control the sampling of the differential output signal onto the capacitor 190. When the switches S0a and S0b are closed the output voltage of the amplifier 102 is sampled onto the capacitor 190. When they are opened the signal is held on the capacitor 190.

On the output side of the capacitor switches S1a and S1b can be closed to connect the capacitor 190 to the integrator 192 such that the charge of the capacitor is added to the integrator in an additive sense. Switches S2a and S2b can be closed so as to swap the plates of the capacitor 190 over such that it charge shares with the integrator 192 in a subtractive manner. By sampling and integrating over many cycles of Vcm being swapped between Vcm1 and Vcm2 the difference in the differential can be extracted and integrated, and if the output of the integrator 192 exceeds a threshold value this is indicative of an input becoming open circuit. The output of the integrator 192 may be fed to a comparator - such as a window comparator (not shown) to compare the output with a threshold value. The integrator 192 may be formed as a leaky integrator by placing a resistor 194 in parallel with the integration capacitor 196 so that amplifier offsets to not cause the integrator to overflow.

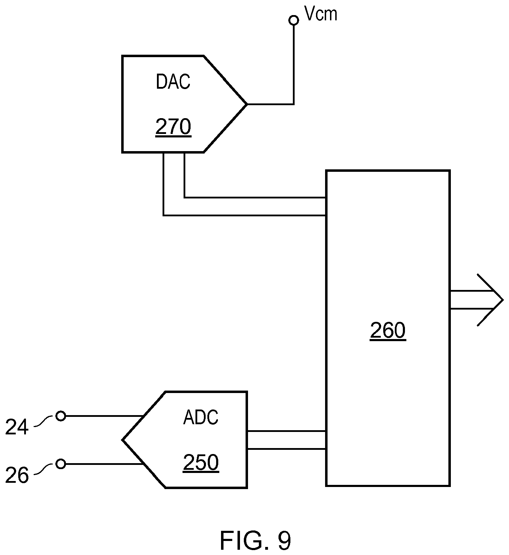

A similar functionality of looking at the differential signal with one common mode voltage and seeing how it changes when a second common mode voltage is selected could be performed in the digital domain, as illustrated in Figure 9. Here a differential analog to digital converter 250 has its inputs connected to the output nodes 24 and 26 of the amplifier 102 and provides digital data to a digital processing block 260. A digital to analog converter 270 is also connected to a digital processing block and can be used to set and modulate the value $V_{cm}$.

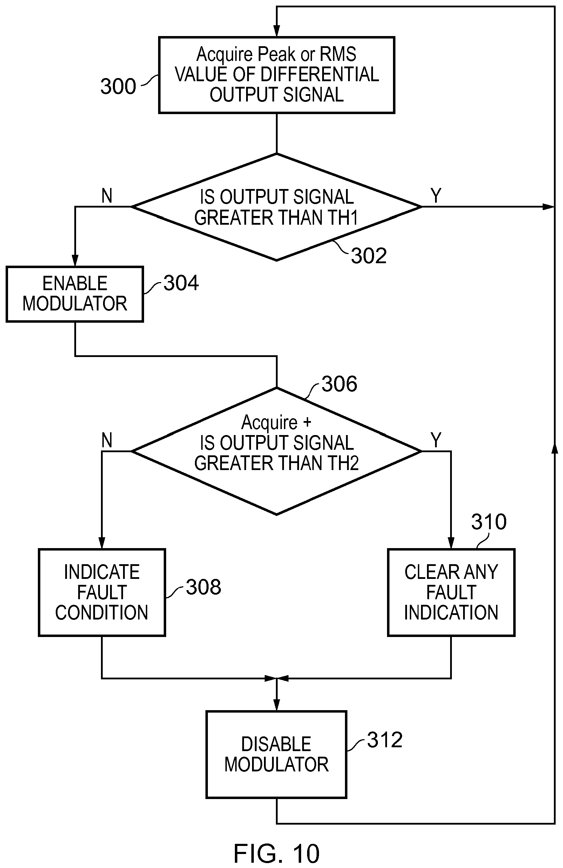

Figure 10 illustrates a flow chart of a process that may, in this example, be performed by the digital processor 260. The flow chart starts at step 300 where the output of the analog to digital converter 50 is analyzed in order to identify a peak, RMS or other meaningful representation of the value of the differential output signal. Processing then passes the step 302 where the value representative of the output signal is compared with a first threshold $TH_1$. If the value of the output signal is greater than $TH_1$ control then returns to step 300 as a signal representative of a current flowing has been output by the current transformer and burden resistor combination. Consequently the integrity of the input circuit 80 and connector 90 can be assumed to be good. If the output signal is less that the threshold then control passes to step 304 where common mode change is enabled and then to step 306 where the peak to peak value of the differential output signal with the modulator operative is acquired and then compared with the second threshold TH2. If the output signal is greater than the value of TH2, suggesting that the connection 90 has failed, then control passes to step 308 where a fault flag is set. However if the output signal is less than the value of $TH_2$ then control passes to step 310 where any preexisting fault flags are cleared. From step 308 or 310 control is then passed to step 312 where the common mode adjustment function is disabled. From there control is then returned to step 300 such that the monitoring process can continue.

The open circuit detector could be run only when a disconnect event is suspected, as set out in the flow chart of Figure 10. However it could also be periodically, on demand, or permanently. In another approach the common mode may be modulated and the part of the differential signal attributable to that modulation extracted by various means whether through time domain or frequency domain analysis, and it can indicate an amount of imbalance in the system. Any change in this value can be indicative of a change in the source impedance and therefore be used to flag a fault condition. The perturbation in the output signal caused by running the disconnect detector is small and in many systems may be ignored. However, in some systems the magnitude of the perturbation may be estimated or learnt and removed from the output signal. This is most easily performed in the digital domain once the output of the difference amplifier has been converted by an analog to digital converter, however subtraction could also be performed in the analog domain if desired.

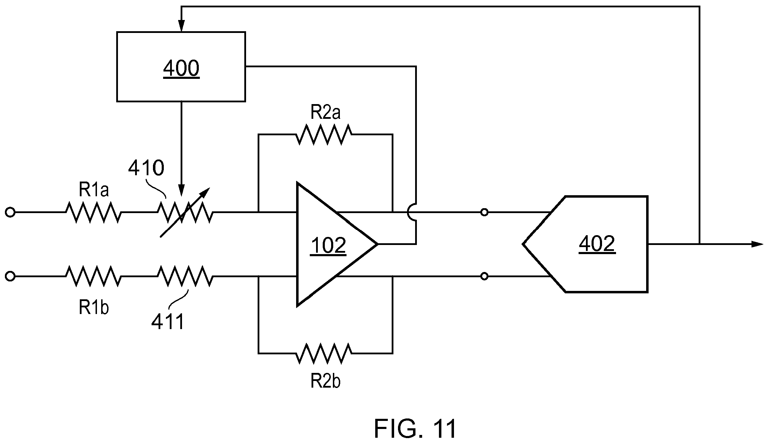

This approach described herein can also be extended to check the common mode rejection ratio of a differential circuit and to adjust it. Figure 11 schematically illustrates an arrangement where a controller periodically modulates the target common mode voltage of an amplifier 102 and is arranged to monitor the differential outputs of the amplifier, either directly as disclosed hereinbefore or indirectly, for example by way of receiving an output of an analog to digital converter 402 which is provided to digitize the output of the amplifier for use by other circuits not shown. Furthermore the controller 400 may examine the conversion of the common mode voltage to a differential signal and on the basis of that conversion adjust an electrically adjustable resistance 410 so as to reduce mismatch between the channel responses. A matching resistance 411 is provided in the opposing input channel and has a value approximately equal to the mid-range value of the adjustable resistor 410.

Because it is possible to look for a correlation between the common mode gain and the modulation, the modulation can be formed of many possible signal types, such as a sinusoidal signal of known frequency; a square wave of known frequency; a slew rate limited square wave; a triangle wave; a digitally generated signal of arbitrary profile; a pseudo-random signal; or even noise.

It is thus possible to provide an apparatus for monitoring the differential response of a circuit and also to provide a disconnect detector which does not require adding further circuitry, such as current sources or impedances, to the input stage of the amplifier. The description has focused on circuits where the common mode output voltage is adjusted and this modifies the current flow in an input circuit. A similar approach can be used with circuits that allow the common mode input voltage to be set to a target value.

The teachings of this disclosure can be applied in a wide variety of uses, for example in industrial, automotive, aerospace and medical domains to make sure a connection is made between a transducer and a signal processing circuit, and/or to check for degradation of the transducer. It can also be used to monitor the common mode rejection performance of differential signal processing circuits (which have wide range of uses) and to adjust components to improve the common mode rejection performance of the circuit.

**Claims**

1. A method of detecting channel imbalance in a circuit that comprises a differential amplifier (102), the method **characterized by** comprising modulating a common mode voltage at a differential output (24, 26) of the differential amplifier, and monitoring a differential voltage at the output for changes that are correlated with changes in the common mode voltage at the output.

2. A method as claimed in claim 1, further comprising using a relative change in magnitudes of the modulation of the common mode voltage at the output and the magnitude of the changes in the differential voltage to estimate the channel imbalance.

3. A method of detecting degradation or failure of a signal path (90) from a sensor (85) to a differential amplifier (102), the method comprising using the method of any preceding claim to identify channel imbalance above an acceptable threshold.

4. A method as claimed in claim 3, comprising providing secondary paths to a common node (101), the secondary paths having deliberately different impedances, such that in the event of disconnection of the sensor from sensor from one or both differential signal input nodes, secondary paths introduce a common mode gain.

5. A method as claimed in any preceding claim, in which the modulation includes at least one of

   a) a sinusoidal signal of known frequency;
   b) a square wave of known frequency;
   c) a slew rate limited square wave;
   d) a triangle wave;
   e) a digitally generated signal of arbitrary profile;
   f) a pseudo-random signal; or
   g) noise.

6. A method as claimed in any preceding claim, wherein any one or more of the following applies:

   (a) the method further comprises trimming or adjustment of components (410) within the differential signal processing circuit to reduce the imbalance;
   (b) the modulation is applied intermittently.

7. An apparatus for detecting channel imbalance in a differential signal processing system comprising a differential amplifier (102), the differential amplifier having a node (60) for controlling a common mode value of a differential output signal of the differential amplifier, the apparatus comprising a common mode output modulator for modulating a common mode component of the differential output signal, and a processor (150) for examining a correlation between the differential output signal and the common mode modulation so as to identify channel imbalance.

8. An apparatus as claimed in claim 7, further comprising at least one adjustable component (410) in at least one of the channels, wherein the component is adjustable in response to the identification of channel imbalance to reduce the imbalance.

9. An apparatus as claimed in claim 8, in which the at least one component comprises an electrically adjustable resistance.

10. An apparatus as claimed in any of claims 7 to 9, in which the apparatus is adapted to issue a signal to indicate when the imbalance exceeds a threshold.

11. An apparatus as claimed in any of claims 7 to 10, further including components to induce a change in channel imbalance in response to a disconnection of an input arrangement, such that a disconnection of the input can be identified.

12. An apparatus as claimed in any of claims 7 to 11, in which any one or more of the following applies:

(a) the difference amplifier has a circuit responsive to a control node for controlling a common mode output voltage or common mode output current of the difference amplifier;
(b) the modulator comprises a signal generator or a digital to analog converter (270);
(c) the processor comprises a digital signal processor (260);
(d) the processor comprises an analog circuit arranged to convert the differential signal into a single ended signal.

13. An apparatus as claimed in any of claims 7 to 12, wherein the signal generator provides a time varying reference signal for adjusting the common mode output voltage of the differential amplifier, such that the input current becomes modulated in response to the reference signal, the reference signal being applied to the node that sets the common mode output voltage of the amplifier, and wherein the apparatus further comprises a circuit for detecting when the common mode gain of the amplifier exceeds a threshold.

14. A transducer (80) in combination with the apparatus as claimed in claim 7.

15. A method as claimed in claim 1, further comprising estimating channel imbalance as a function of a magnitude of the correlation.

**Patentansprüche**

1. Verfahren zum Detektieren eines Kanalungleichgewichts in einer Schaltung, die einen Differenzialverstärker (102) umfasst, wobei das Verfahren **gekennzeichnet ist durch**:
Modulieren einer Gleichtaktspannung an einem Differenzialausgang (24, 26) des Differenzialverstärkers und Überwachen einer Differenzialspannung an dem Ausgang nach Änderungen, die mit Änderungen in der Gleichtaktspannung an dem Ausgang korreliert sind.

2. Verfahren nach Anspruch 1, das ferner umfasst, eine relative Änderung von Stärken der Modulation der Gleichtaktspannung an dem Ausgang und die Stärke der Änderungen der Differenzialspannung zu verwenden, um das Kanalungleichgewicht zu schätzen.

3. Verfahren zum Detektieren einer Verschlechterung oder eines Ausfalls eines Signalwegs (90) von einem Sensor (85) zu einem Differenzialverstärker (102), wobei das Verfahren umfasst, das Verfahren nach einem vorhergehenden Anspruch zu verwenden, um ein Kanalungleichgewicht über einem annehmbaren Schwellenwert zu identifizieren.

4. Verfahren nach Anspruch 3, das umfasst, sekundäre Wege zu einem gemeinsamen Knoten (101) bereitzustellen, wobei die sekundären Wege absichtlich verschiedene Impedanzen besitzen, so dass im Fall eines Trennens des Sensors vom Sensor von einem oder beiden Differenzialsignaleingangsknoten, sekundäre Wege eine Gleichtaktverstärkung einführen.

5. Verfahren nach einem vorhergehenden Anspruch, wobei die Modulation mindestens eines enthält von:

a) einem sinusförmigen Signal bekannter Frequenz;
b) einer Quadratwelle bekannter Frequenz;
c) einer Quadratwelle mit begrenzter Anstiegsrate;
d) einer Dreieckwelle;
e) eines digital erzeugten Signals willkürlichen Profils;

f) eines pseudo-zufälligen Signals; oder

g) Rauschen.

**6.** Verfahren nach einem vorhergehenden Anspruch, wobei eines oder mehrere des Folgenden zutreffen:

(a) das Verfahren umfasst ferner das Einpassen oder Anpassen von Komponenten (410) innerhalb der Differenzialsignalverarbeitungsschaltung, um das Ungleichgewicht zu verringern;

(b) die Modulation wird intermittierend angewendet.

**7.** Vorrichtung zum Detektieren eines Kanalungleichgewichts in einem Differenzialsignalverarbeitungssystem, das einen Differenzialverstärker (102) umfasst, wobei der Differenzialverstärker einen Knoten (60) zum Steuern eines Gleichtaktwertes des Differenzialausgangssignals des Differenzialverstärkers besitzt, wobei die Vorrichtung einen Gleichtaktausgangsmodulator zum Modulieren einer Gleichtaktkomponente des Differenzialausgangssignals und einen Prozessor (150) zum Untersuchen einer Korrelation zwischen dem Differenzialausgangssignal und der Gleichtaktmodulation, um ein Kanalungleichgewicht zu identifizieren, umfasst.

**8.** Vorrichtung nach Anspruch 7, die ferner mindestens eine abstimmbare Komponente (410) in mindestens einem der Kanäle umfasst, wobei die Komponente als Reaktion auf die Identifikation eines Kanalungleichgewichts anpassbar ist, um das Ungleichgewicht zu verringern.

**9.** Vorrichtung nach Anspruch 8, wobei die mindestens eine Komponente einen elektrisch einstellbaren Widerstand umfasst.

**10.** Vorrichtung nach einem der Ansprüche 7 bis 9, wobei die Vorrichtung ausgelegt ist, ein Signal auszugeben, um anzugeben, wenn das Ungleichgewicht einen Schwellenwert überschreitet.

**11.** Vorrichtung nach einem der Ansprüche 7 bis 10, die ferner Komponenten enthält, um eine Änderung eines Kanalungleichgewichts als Reaktion auf ein Trennen einer Eingangsanordnung zu induzieren, so dass ein Trennen des Eingangs identifiziert werden kann.

**12.** Vorrichtung nach einem der Ansprüche 7 bis 11, wobei eines oder mehrere des Folgenden zutreffen:

(a) der Differenzverstärker besitzt eine Schaltung, die auf einen Steuerknoten reagiert, um eine Gleichtaktausgangsspannung oder einen Gleichtaktausgangsstrom des Differenzverstärkers zu steuern;

(b) der Modulator umfasst einen Signalgenerator oder einen Digital-/AnalogWandler (270);

(c) der Prozessor umfasst einen Digitalsignalprozessor (260);

(d) der Prozessor umfasst eine Analogschaltung, die ausgelegt ist, das Differenzialsignal in ein "Single-ended"-Signal umzusetzen.

**13.** Vorrichtung nach einem der Ansprüche 7 bis 12, wobei der Signalgenerator ein zeitlich variierendes Referenzsignal zum Anpassen der Gleichtaktausgangsspannung des Differenzialverstärkers liefert, so dass der Eingangsstrom als Reaktion auf das Referenzsignal moduliert wird, wobei das Referenzsignal auf den Knoten angewendet wird, der die Gleichtaktausgangsspannung des Verstärkers einstellt, und wobei die Vorrichtung ferner eine Schaltung zum Detektieren, wann die Gleichtaktverstärkung des Verstärkers einen Schwellenwert überschreitet, umfasst.

**14.** Wandler (80) in Kombination mit der Vorrichtung nach Anspruch 7.

**15.** Verfahren nach Anspruch 1, das ferner umfasst, das Kanalungleichgewicht als eine Funktion einer Größe der Korrelation zu schätzen.

**Revendications**

**1.** Procédé de détection d'un déséquilibre de canal dans un circuit qui comprend un amplificateur différentiel (102), le procédé étant **caractérisé en ce qu'**il comprend la modulation d'une tension en mode commun au niveau d'une sortie différentielle (24, 26) de l'amplificateur différentiel, et la surveillance d'une tension différentielle au niveau de la sortie quant à des changements qui sont corrélés à des changements de la tension en mode commun au niveau de la sortie.

**2.** Procédé selon la revendication 1, comprenant en outre l'utilisation d'un changement relatif de grandeurs de la modulation de la tension en mode commun au niveau de la sortie et de la grandeur des changements de la tension différentielle pour estimer le déséquilibre de canal.

**3.** Procédé de détection d'une dégradation ou défaillance d'un trajet de signal (90) allant d'un capteur (85) à un amplificateur différentiel (102), le procédé comprenant l'utilisation du procédé selon l'une quelconque des revendications précédentes pour identifier un déséquilibre du canal au-dessus d'un seuil acceptable.

**4.** Procédé selon la revendication 3, comprenant la fourniture de trajets secondaires vers un nœud commun (101), les trajets secondaires ayant des impédances volontairement différentes, de sorte que, dans le cas d'une déconnexion du capteur à partir d'un capteur d'un ou des deux nœuds d'entrée de signal différentiel, les trajets secondaires introduisent un gain de mode commun.

**5.** Procédé selon l'une quelconque des revendications précédentes, dans lequel la modulation comprend au moins l'un parmi

a) un signal sinusoïdal de fréquence connue ;
b) une onde carrée de fréquence connue ;
c) une onde carrée à vitesse de balayage limitée ;
d) une onde triangulaire ;
e) un signal généré numériquement de profil arbitraire ;
f) un signal pseudo-aléatoire ; ou
g) bruit.

**6.** Procédé selon l'une quelconque des revendications précédentes, dans lequel l'un quelconque ou plusieurs de ce qui suit s'appliquent :

(a) le procédé comprend en outre la réduction ou l'ajustement de composants (410) dans le circuit de traitement de signal différentiel pour réduire le déséquilibre ;
(b) la modulation est appliquée par intermittence.

**7.** Appareil pour détecter un déséquilibre de canal dans un système de traitement de signal différentiel comprenant un amplificateur différentiel (102), l'amplificateur différentiel ayant un nœud (60) pour commander une valeur de mode commun d'un signal de sortie différentiel de l'amplificateur différentiel, l'appareil comprenant un modulateur de sortie de mode commun pour moduler une composante de mode commun du signal de sortie différentiel, et un processeur (150) pour examiner une corrélation entre le signal de sortie différentiel et la modulation de mode commun afin d'identifier un déséquilibre de canal.

**8.** Appareil selon la revendication 7, comprenant en outre au moins un composant ajustable (410) dans au moins l'un des canaux, dans lequel le composant est ajustable en réponse à l'identification d'un déséquilibre de canal pour réduire le déséquilibre.

**9.** Appareil selon la revendication 8, dans lequel le au moins un composant comprend une résistance ajustable électriquement.

**10.** Appareil selon l'une quelconque des revendications 7 à 9, dans lequel l'appareil est adapté pour émettre un signal pour indiquer le moment où le déséquilibre dépasse un seuil.

**11.** Appareil selon l'une quelconque des revendications 7 à 10, comprenant en outre des composants pour induire un changement de déséquilibre de canal en réponse à une déconnexion d'un agencement d'entrée, de sorte qu'une déconnexion de l'entrée peut être identifiée.

**12.** Appareil selon l'une quelconque des revendications 7 à 11, dans lequel l'un quelconque ou plusieurs de ce qui suit s'appliquent :

(a) l'amplificateur différentiel a un circuit sensible à un nœud de commande pour commander une tension de sortie en mode commun ou un courant de sortie en mode commun de l'amplificateur différentiel ;
(b) le modulateur comprend un générateur de signal ou un convertisseur numérique-analogique (270) ;

(c) le processeur comprend un processeur de signal numérique (260) ;

(d) le processeur comprend un circuit analogique agencé pour convertir le signal différentiel en un signal asymétrique.

**13.** Appareil selon l'une quelconque des revendications 7 à 12, dans lequel le générateur de signal fournit un signal de référence variant dans le temps pour ajuster la tension de sortie en mode commun de l'amplificateur différentiel, de sorte que le courant d'entrée devient modulé en réponse au signal de référence, le signal de référence étant appliqué au nœud qui établit la tension de sortie en mode commun de l'amplificateur, et dans lequel l'appareil comprend en outre un circuit pour détecter le moment où le gain de mode commun de l'amplificateur dépasse un seuil.

**14.** Transducteur (80) en combinaison avec l'appareil selon la revendication 7.

**15.** Procédé selon la revendication 1, comprenant en outre l'estimation d'un déséquilibre de canal en fonction d'une grandeur de la corrélation.

FIG. 1

FIG. 2

FIG. 3

FIG. 4

FIG. 5

110a = 110b = R1
112a = 112b = R2

EP 3 524 988 B1

FIG. 6

FIG. 7

FIG. 8

FIG. 9

FIG. 10

FIG. 11

**EP 3 524 988 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080100308 A